(19) **Europäisches Patentamt**
**European Patent Office**
**Office européen des brevets**

(11) **EP 4 390 415 B1**

(12) **EUROPEAN PATENT SPECIFICATION**

(45) Date of publication and mention
of the grant of the patent:
**11.06.2025 Bulletin 2025/24**

(21) Application number: **23209318.7**

(22) Date of filing: **13.11.2023**

(51) International Patent Classification (IPC):
***G01R 31/36*** (2020.01)    ***G01R 31/385*** (2019.01)

(52) Cooperative Patent Classification (CPC):
**G01R 31/3865; G01R 31/36;** G01R 31/52;
Y02E 60/10; Y02P 70/50

(54) **METHOD OF TESTING LITHIUM-ION SECONDARY BATTERY, AND METHOD OF PRODUCING LITHIUM-ION SECONDARY BATTERY USING THE SAME**

VERFAHREN ZUM TESTEN EINER LITHIUM-IONEN-SEKUNDÄRBATTERIE UND VERFAHREN ZUR HERSTELLUNG EINER LITHIUM-IONEN-SEKUNDÄRBATTERIE DAMIT

PROCÉDÉ DE TEST DE BATTERIE SECONDAIRE AU LITHIUM-ION ET PROCÉDÉ DE PRODUCTION DE BATTERIE SECONDAIRE AU LITHIUM-ION L'UTILISANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **20.12.2022 JP 2022203121**

(43) Date of publication of application:
**26.06.2024 Bulletin 2024/26**

(73) Proprietor: **TOYOTA JIDOSHA KABUSHIKI KAISHA**
**Toyota-shi, Aichi-ken, 471-8571 (JP)**

(72) Inventors:
• **HARA, Ruri**
**Toyota-shi, 471-8571 (JP)**
• **SAITO, Yamato**
**Toyota-shi, 471-8571 (JP)**
• **ARAKAWA, Toshiya**
**Toyota-shi, 471-8571 (JP)**

(74) Representative: **D Young & Co LLP**
**3 Noble Street**
**London EC2V 7BQ (GB)**

(56) References cited:
**JP-A- 2019 113 450**

## Description

FIELD

The present application relates to methods of testing a lithium-ion secondary battery, and methods of producing a lithium-ion secondary battery by the use of such a testing method.

BACKGROUND

A lithium-ion secondary battery has high power and high capacity, and is widely used as a power source for mobile phones, personal computers, etc. Because of its lightness and high energy density, a lithium-ion secondary battery is also used as an on-board power source for HEVs (Hybrid Electric Vehicles), BEVs (Battery Electric Vehicles), etc.

In the step of producing lithium ion-secondary batteries, minute metallic foreign materials may be contaminated in the batteries from the outside. Such a contaminated metallic foreign material causes internal short circuits in the batteries, and thus, influences determination whether each battery is good or bad.

Conventionally, whether a lithium-ion secondary battery is good or bad is determined after the battery is charged, and then left to stand for a certain period of time based on the amount of its voltage drop for the certain period. The voltage of a lithium-ion secondary battery that has been left to stand for a certain period of time has dropped due to its self-discharge. When metallic foreign materials are contaminated in this battery, the voltage further drops. Therefore, whether the battery is good or bad can be determined by the amount of the voltage drop of the battery during the leaving step. However, it takes a lot of time to determine whether the battery is good or bad by a conventional method comprising such a leaving step.

For reducing the time for determining whether such a battery is good or bad, patent literature 1 discloses the following testing method. That is, the testing method disclosed in patent literature 1 comprises: building a circuit with an electrical storage device to be tested, and a power supply; and determining whether the electrical storage device is good or bad based on a current IB passing through the circuit. Patent literature 1 also discloses: the current applying step of building a circuit with a charged electrical storage device and a power supply, and passing the current IB by the use of the power supply to the circuit in the direction of charging or discharging the electrical storage device; and the determination step of determining whether the electrical storage device is good or bad based on the converging state of the current IB passing through the circuit in the current applying step, wherein in the current applying step, the output voltage VS of the power supply is changed from the initial value as time passes.

As described above, in the testing method of patent literature 1, the current flowing between the device and the power supply is measured, which makes the time to determine whether the electrical storage device is good or bad shorter than that based on the amount of voltage drop. The testing method of patent literature 1 brings high accuracy of the determination because the current is measured therein, which is also the feature thereof.

CITATION LIST

Patent Literature

Patent Literature 1: JP 2019-113450 A

SUMMARY

Technical Problem

Lithium iron phosphate ($LiFePO_4$), which has an olivine structure, is known as a cathode active material used for lithium-ion secondary batteries. Due to its high safety, lithium iron phosphate is expected to be used for on-board lithium ion secondary batteries. In contrast, the plateau region of lithium iron phosphate is large. The voltage hardly changes in the plateau region. Thus, it is difficult to determine whether such a battery is good or bad based on the amount of its voltage drop. In addition, the range of the charging rate is very narrow in the region other than the plateau region. Thus, it is not practical to determine whether such a battery is good or bad when its charging rate is in the region other than the plateau region.

The inventors of the present disclosure then researched the determination whether a lithium-ion secondary battery was good or bad by: connecting the battery charged until the charging rate reached the plateau region to a test power supply that was adjusted, so that the voltage thereof was equal to the battery voltage; and measuring a leakage current flowing through a circuit. The voltage hardly changed in the plateau region as described above while having slightly changed due to self-discharge. This slight change of the voltage made a potential difference between the battery and the test power supply, and thus, a very weak leakage current flew through the circuit. Therefore, the inventors of the present disclosure thought that the determination whether the battery was good or bad was enabled based on this very weak leakage current. However, as a result of their extensive research, the inventors of the present disclosure hit a new problem such that the temperature of the battery affected the leakage current flowing through the circuit, which might decrease the accuracy of the determination whether the battery was good or bad, and prolong the determination.

With the above actual circumstances in view, an object of the present disclosure is to provide a method of testing a lithium-ion secondary battery, the method enabling whether the battery is good or bad to be determined with high accuracy in a short time even when lithium iron phosphate is used as a cathode active material, and a method of producing a lithium-ion secondary battery by the use of the testing method.

Solution to Problem

As one aspect for solving the above problems, the present disclosure is provided with a method of testing a lithium-ion secondary battery, the battery comprising a cathode containing lithium iron phosphate as a cathode active material, an anode containing a carbon material as an anode active material, and an electrolyte layer arranged between the cathode and the anode, the method comprising: adjusting a charging rate of the lithium-ion secondary battery to be in a plateau region and to be in the range from 25 to 35% or 70 to 90%; setting voltage of a test power supply to a voltage equal to or higher than voltage of the lithium-ion secondary battery; building a circuit by connecting the lithium-ion secondary battery and the test power supply; measuring a leakage current that flows through the circuit until the leakage current converges; and determining whether the lithium-ion secondary battery is good or bad based on the leakage current after the leakage current has converged.

In said measuring a leakage current, the voltage of the test power supply may be raised over time.

In said adjusting a charging rate, the charging rate of the lithium-ion secondary battery may be adjusted, so that dV/dT is -0.05 mV/°C to 0.05 mV/°C where V is the voltage of the lithium-ion secondary battery, and T is temperature of the lithium-ion secondary battery.

As one aspect for solving the above problems, the present disclosure is provided with a method of producing a lithium-ion secondary battery, the method comprising: making the lithium-ion secondary battery comprising a cathode containing lithium iron phosphate as a cathode active material, an anode containing a carbon material as an anode active material, and an electrolyte layer arranged between the cathode and the anode; and performing the above-described testing method.

Advantageous Effects

The method of testing a lithium-ion secondary battery of the present disclosure enables whether the battery is good or bad to be determined with high accuracy in a short time even when lithium iron phosphate is used as a cathode active material.

The method of producing a lithium-ion secondary battery of the present disclosure enables whether the battery is good or bad to be determined with high accuracy in a short time, and thus, can suppress shipment of bad batteries, and shorten the production period.

BRIEF DESCRIPTION OF DRAWINGS

Fig. 1 is the flowchart of the first embodiment;
Fig. 2 shows a model circuit that is a typical example used in the first embodiment;
Fig. 3 shows a model circuit to which virtual resistance Rim is introduced;
Fig. 4 shows the measurement result of a charging rate-voltage curve;
Fig. 5 shows the correlation between voltage and |dV/dQ| (where V is voltage and Q is capacity);
Fig. 6 shows the results of leakage current measurement; and
Fig. 7 shows the results of temperature sensitivity measurement.

DESCRIPTION OF EMBODIMENTS

(A) Method of Testing Lithium-Ion Secondary Battery

A method of testing lithium-ion secondary battery according to the present disclosure will be described with embodiments thereof.

[First Embodiment]

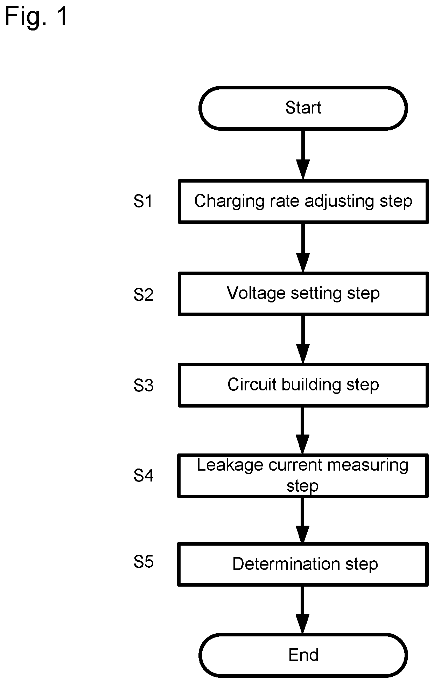

The first embodiment is a method of testing a lithium-ion secondary battery comprising a cathode containing lithium iron phosphate as a cathode active material, an anode containing a carbon material as an anode active material, and an electrolyte layer arranged between the cathode and the anode, the method comprising: the charging rate adjusting step S1 of adjusting the charging rate of the lithium-ion secondary battery to be in a plateau region and to be in the range from 25 to 35% or 70 to 90%; the voltage setting step S2 of setting the voltage of a test power supply to be equal to that of the lithium-ion secondary battery; the circuit building step S3 of building a circuit by connecting the lithium-ion secondary battery and the test power supply; the leakage current measuring step S4 after the voltage setting step S2 and the circuit building step S3, the step S4 being to measure a leakage current flowing from the lithium-ion secondary battery until the leakage current converges; and the determination step S5 of determining whether the lithium-ion secondary battery is good or bad based on the converging state of the leakage current. Fig. 1 is the flowchart of the first embodiment.

<Lithium-Ion Secondary Battery>

The first embodiment is for a lithium-ion secondary battery comprising a cathode containing lithium iron phosphate ($LiFePO_4$) as a cathode active material, an anode containing a carbon material as an anode active material, and an electrolyte layer arranged between the cathode and the anode.

The lithium-ion secondary battery used in the first embodiment may be a nonaqueous electrolyte lithium-ion secondary battery, and may be an all-solid-state lithium-ion secondary battery. The lithium-ion secondary battery used in the first embodiment may be a stacked lithium-ion secondary battery, and may be a wound lithium-ion secondary battery. The lithium-ion secondary battery may be a bipolar battery. In addition, the lithium-ion secondary battery used in the first embodiment may be provided with plural cathodes, plural anodes and plural electrolyte layers. Hereinafter the structure of each component of a lithium-ion secondary battery with a nonaqueous electrolyte will be described as one example.

(Cathode)

The cathode is provided with a cathode current collector, and (a) cathode active material layer(s) that is/are formed on one or both side(s) of the cathode current collector.

The cathode current collector is an electroconductive member in the form of sheet. Examples of the material of the cathode current collector include a foil of stainless steel, iron, copper, aluminum, titanium, nickel, or the like, and a foil of an alloy containing two or more of them. Metal foil as used herein may be surface-treated in a predetermined way, for example, may be plated. The cathode current collector may be formed of a plurality of sheets of metal foil. In this case, the sheets of this metal foil may be connected to each other with an adhesive or the like, and may be connected to each other by pressing or the like. The shape of the cathode current collector is not particularly limited, and may be, for example, substantially rectangular. The thickness of the cathode current collector is not particularly limited, and is, for example, 1 $\mu$m to 1 mm.

The cathode active material layer(s) contain(s) lithium iron phosphate as a cathode active material. While the cathode active material layer(s) may contain lithium iron phosphate only as a cathode active material, the cathode active material layer(s) may be contain (a) cathode active material(s) other than lithium iron phosphate as long as the proportion of lithium iron phosphate on the basis of the total mass of the cathode active materials is no less than 80 wt%. Examples of the cathode active material(s) other than lithium iron phosphate include known cathode active materials that are used for lithium-ion secondary batteries, such as lithium composite metal oxides having a layer structure, a spinel structure, etc. (such as $LiNi_{1/3}Co_{1/3}Mn_{1/3}O_2$, $LiNiO_2$, $LiCoO_2$, $LiFeO_2$, $LiMn_2O_4$, and $LiNi_{0.5}Mn_{1.5}O_4$).

The cathode active material layer(s) may optionally contain conductive additive and/or binder. Examples of the conductive additive include carbon materials such as acetylene black, carbon black, and graphite. Examples of the binder include fluorine-containing resins such as polyvinylidene fluoride, polytetrafluoroethylene, and fluoroelastomers; styrene-butadiene rubber (SBR); and carboxymethyl cellulose.

The shape of the cathode active material layer(s) may be substantially rectangular without any particular limitations. The thickness of each of the cathode active material layer(s) is not particularly limited, and, for example, ranges from 1 $\mu$m to 1 mm. The area of each of the cathode active material layer(s) may be smaller than (an) anode active material layer(s) described later. The content of each material in each of the cathode active material layer(s) may be appropriately set according to the target battery performance without any particular limitations. The cathode active material layer(s) may contain (a) material(s) other than the foregoing materials.

(Anode)

The anode is provided with an anode current collector, and the anode active material layer(s) that is/are formed on one or both side(s) of the anode current collector.

The anode current collector is an electroconductive member in the form of sheet. Examples of the material of the anode current collector include a foil of stainless steel, iron, copper, aluminum, titanium, nickel, or the like, and a foil of an alloy containing two or more of them. Metal foil as used herein may be surface-treated in a predetermined way, for example, may be plated. The anode current collector may be formed of a plurality of sheets of metal foil. In this case, the sheets of this metal foil may be connected to each other with an adhesive or the like, and may be connected to each other by pressing or the like. The shape of the anode current collector is not particularly limited, and may be, for example, substantially rectangular. The thickness of the anode current collector is not particularly limited, and is, for example, 1 $\mu$m to 1 mm.

The anode active material layer(s) contain(s) a carbon material as an anode active material. Examples of the carbon material include natural graphite, artificial graphite, non-graphitizable carbon (hard carbon), and graphitizable carbon (soft carbon). While the anode active material layer(s) may contain a carbon material only as an anode active material, the anode active material layer(s) may contain (an) anode active material(s) other than the carbon material as long as the proportion of the carbon material on the basis of the total mass of the anode active materials is no less than 80 wt%. Examples of the anode active material(s) other than the carbon material include known anode active materials that are used for lithium-ion secondary batteries, such as lithium transition metal composite oxides (e.g., lithium-titanium composite oxides such as $Li_4Ti_5O_{12}$), silicon, and tin.

The anode active material layer(s) may optionally contain binder. Examples of the binder include binders that can be used for the cathode active material layer(s).

(Electrolyte Layer)

The electrolyte layer contains a separator and a nonaqueous electrolyte.

An example of the separator is a porous sheet (film) made from a resin such as polyethylene (PE), polypropylene (PP), polyester, cellulose, and polyamides. Such a porous sheet may have a single-layered structure, and may have a structure of layering two or more layers. The thickness of the separator is not particularly limited, and may be 10 $\mu$m to 1 mm in view of maintaining the electrical insulation between the cathode and the anode.

The nonaqueous electrolyte contains a nonaqueous solvent, and a supporting salt. As the nonaqueous solvent, a known nonaqueous solvent that is used for lithium-ion secondary batteries can be used. Examples of such a nonaqueous solvent include organic solvents such as various carbonates, ethers, esters, nitriles, sulfones, and lactones.

Specific examples of such a nonaqueous solvent include ethylene carbonate (EC), propylene carbonate (PC), diethyl carbonate (DEC), dimethyl carbonate (DMC), and ethyl methyl carbonate (EMC). As the supporting salt, a known supporting salt that is used for lithium-ion secondary batteries can be used. Examples of such a supporting salt include lithium salts such as $LiPF_6$, $LiBF_4$, $LiClO_4$, and $LiAsF_6$. The concentration of the supporting salt in the nonaqueous electrolyte is not particularly limited, and may be, for example, 0.5 mol/L to 1.5 mol/L.

(Method of Making Lithium-Ion Secondary Battery)

Such a lithium-ion secondary battery can be made by a known method. Hereinafter one example of the method of making the lithium-ion secondary battery will be described.

First, the anode can be obtained by: obtaining a slurry by mixing, with a solvent, the material that is to constitute the anode active material layer(s); thereafter, applying the slurry onto one or both sides of the anode current collector; and drying the resultant. Alternatively, the anode can be obtained by: obtaining the anode active material layer by mixing with a mortar or the like, and then pressing the material that is to constitute the anode active material layer; arranging this anode active material layer on one or both sides of the anode current collector; and further pressing the resultant. The cathode can be obtained in the same way as any of them. An electrode body is obtained by layering the obtained cathode and anode via the separator. For example, the obtained electrode body may be wound in a flat form. Then, the lithium-ion secondary battery is obtained by: putting the electrode body and the nonaqueous electrolyte into a wrapping body (battery case); and connecting terminals (a cathode terminal and an anode terminal) provided for the wrapping body to the current collectors (the cathode current collector and the anode current collector).

(Characteristic and Problems of Lithium-Ion Secondary Battery Using Lithium Iron Phosphate)

As described above, the lithium-ion secondary battery used in the first embodiment uses lithium iron phosphate as a cathode active material. The plateau region of such a battery is known to be large. The plateau region is the region where the voltage hardly changes showing the correlation between the capacity Q or the charging rate (SOC: State Of Charge), and the voltage V of the battery. Specifically, the plateau region is the region where |dV/dQ| is no more than 0.005 V/mAh. The extent of the plateau region varies depending on the structure of the battery. As one example, the charging rate in the plateau region ranges from 7 to 99%.

As described, the plateau region of the lithium-ion secondary battery using lithium iron phosphate is large. The voltage hardly changes in the plateau region. Thus, it is difficult to determine whether the lithium-ion secondary battery is good or bad in a conventional manner; that is, after the battery is left to stand for a certain period of time based on the voltage drop for the certain period.

The inventors of the present disclosure then researched the determination whether the lithium-ion secondary battery was good or bad by: connecting the battery charged until the charging rate reached the plateau region to a test power supply that was adjusted, so that the voltage thereof was equal to the battery voltage; and measuring a leakage current that flows through a circuit due to the voltage drop of the battery. The voltage hardly changed in the plateau region as described above while having slightly changed due to self-discharge. This slight change of the voltage made a potential difference between the battery and the test power supply, and thus, a very weak leakage current flew through the circuit. Therefore, the inventors of the present disclosure thought that the determination whether the battery was good or bad was enabled based on this very weak leakage current. However, as a result of their extensive research, the inventors of the present disclosure hit a new problem such that the temperature of the battery affected the leakage current flowing through the circuit, which might decrease the accuracy of the determination whether the battery was good or bad, and prolong the determination.

To solve this problem, in the first embodiment, the leakage current is measured using the lithium-ion secondary battery, which is adjusted to be at a charging rate that is in the plateau region and that brings low temperature sensitivity. Hereinafter each step in the first embodiment will be described.

While the lithium-ion secondary battery is adjusted to be at a charging rate that is in the plateau region and that brings low temperature sensitivity, whether the battery is good or bad cannot be properly determined when the environmental temperature is extremely low or extremely high. Therefore, each step in the first embodiment is carried out at room temperature (5°C to 35°C). In view of further suppressing the influence of the temperature, an air conditioner or the like may be adjusted to make the environmental temperature constant.

<Charging Rate Adjusting Step S1>

The charging rate adjusting step S1 is the step of adjusting the charging rate of the lithium-ion secondary battery to be in the plateau region and to be in the range from 25 to 35% or 70 to 90%. "Adjusting (the charging rate)" means charging or discharging. According to the inventors of the present disclosure, voltage changes due to temperature changes are suppressed when the charging rate of the battery ranges from 25 to 35% or 70 to 90%, which results in stable convergence of the leakage current; that is, low temperature sensitivity of the leakage current. Thereby, whether the battery is good or bad can be determined based on the leakage current with high accuracy in a short time.

In the charging rate adjusting step S1, the lithium-ion secondary battery may be adjusted to be at a charging rate that brings $dV/dT$ of -0.05 mV/°C to 0.05 mV/°C where V is the voltage of the lithium-ion secondary battery, and T is the temperature. According to this, a charging rate that brings lower temperature sensitivity of the leakage current can be set. The temperature T of the lithium-ion secondary battery can be adjusted by adjusting the environmental temperature.

In the charging rate adjusting step S1, typically, the lithium-ion secondary battery is charged if immediately after made. When being a used battery such as a secondhand battery, the lithium-ion secondary battery is typically charged or discharged to be adjusted to be at the target charging rate.

<Voltage Setting Step S2>

The voltage setting step S2 is the step of setting the voltage of a test power supply to be equal to that of the lithium-ion secondary battery. It is necessary to measure the voltage of the lithium-ion secondary battery in advance.

<Circuit Building Step S3>

The circuit building step S3 is the step of connecting the lithium-ion secondary battery and the test power supply to build a circuit. Typically, the circuit building step S3 can be performed by connecting a self-discharge measuring device to the lithium-ion secondary battery. Examples of this self-discharge measuring device include self-discharge measuring devices (BT2152A, BT2152B) manufactured by Keysight Technologies.

The voltage setting step S2 and the circuit building step S3 are performed at random after the charging rate adjusting step S1. That is, the circuit building step S3 may be performed after the voltage setting step S2; and the voltage setting step S2 may be performed after the circuit building step S3. Fig. 1 shows the case where the circuit building step S3 is performed after the voltage setting step S2.

<Leakage Current Measuring Step S4>

The leakage current measuring step S4 is performed after the voltage setting step S2 and the circuit building step S3, and is the step of measuring the leakage current flowing through the circuit until the leakage current converges. The voltage of the lithium-ion secondary battery having been left to stand for a certain period of time has dropped due to its self-discharge. This makes a potential difference between the test power supply and the lithium-ion secondary battery, and thus, the leakage current flows through the circuit. When the voltage drop of the battery converges, the increase of the leakage current also converges. In the leakage current measuring step S4, the leakage current is measured at least until the increase of the leakage current converges.

<Determination Step S5>

The determination step S5 is performed after the leakage current measuring step S4, and is the step of determining whether the lithium-ion secondary battery is good or bad based on the leakage current after having converged . As described above, the voltage of the lithium-ion secondary battery having been left to stand for a certain period of time has dropped due to its self-discharge. At this time, the amount of the voltage drop is larger when metallic foreign materials are contaminated in the lithium-ion secondary battery. This is accompanied with a larger value of the leakage current. Therefore, whether the battery is good or bad can be determined based on the value of the leakage current after having converged. A current value that is a standard for the determination whether the battery is good or bad (standard value) may be appropriately set according to the target battery performance, and the like.

<Mechanism for Determining whether Battery is Good or Bad Using Model Circuit>

Hereinafter, the first embodiment will be described further with a model circuit that is a typical example. Circuits that can be built in the first embodiment are not limited to this. The circuit may be properly set according to the structure of the self-discharge measuring device.

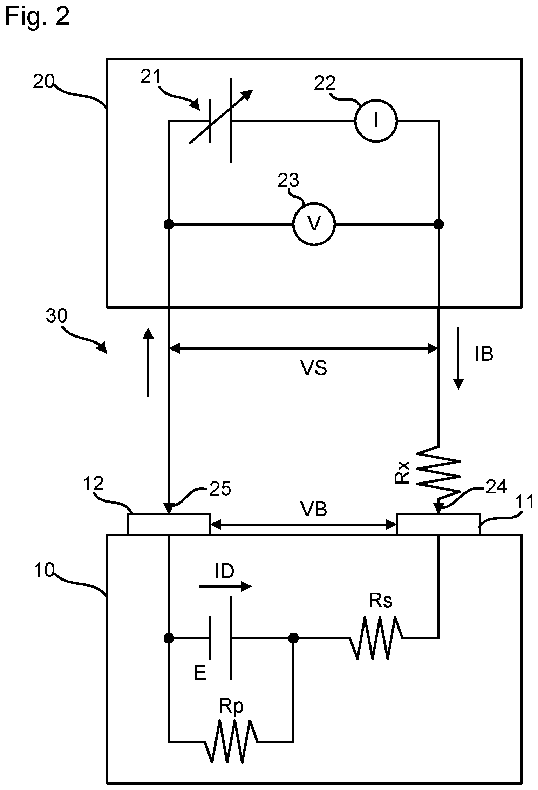

Fig. 2 shows the model circuit that is a typical example used in the first embodiment. As shown in Fig. 2, a lithium-ion secondary battery 10 is provided with a cathode terminal 11 and an anode terminal 12. The lithium-ion secondary battery 10 of Fig. 2 is shown as a model comprising an electric generating element E, internal resistance Rs, and shunt resistance Rp. The internal resistance Rs and the electric generating element E are arranged in series. The shunt resistance Rp is a model of a conductive path formed by minute metallic foreign materials that may enter the lithium-ion secondary battery 10, and is arranged in parallel to the electric generating element E.

A test power supply 20 has a DC power supply 21, an ammeter 22, a voltmeter 23, and probes 24 and 25. The ammeter 22 and the DC power supply 21 are arranged in series, and the voltmeter 23 is arranged in parallel to the DC power supply 21. The output voltage VS of the DC power supply 21 is adjustable. The DC power supply 21 is used to apply the output voltage VS to the lithium-ion secondary battery 10. The ammeter 22 is to measure the current flowing through a circuit 30. The voltmeter 23 is to measure the voltage between the probes 24 and 25. In Fig. 2, the probes 24 and 25 of the test power supply 20 are coupled to the cathode terminal 11 and the anode terminal 12 of the lithium-ion secondary battery 10, respectively, to build the circuit 30.

As shown in Fig. 2, there is parasitic resistance Rx in the circuit 30. The parasitic resistance Rx includes the lead resistance of each part of the test power supply 20, and the contact resistance between the probe 24 and the cathode terminal 11, and between the probe 25 and the anode terminal 25. In Fig. 2, the parasitic resistance Rx in the circuit 30 is drawn as if having been present in the lead on the probe 24 side only, which is, however, just for convenience of the drawing. Actually, the parasitic resistance Rx is present throughout the circuit 30.

To perform the determination whether the lithium-ion secondary battery 10 is good or bad will be described with the above-described model circuit.

First, as pretreatment, the charging rate of the lithium-ion secondary battery 10 is adjusted to be a predetermined charging rate that brings low temperature sensitivity (charging rate adjusting step S1). According to this, the influence of the battery temperature (environmental temperature) is suppressed, which allows whether the battery is good or bad to be determined with high accuracy in a short time.

Next, the battery voltage VB of the lithium-ion secondary battery 10 is measured, and the output voltage VS of the test power supply 20 is adjusted to be equal to the battery voltage VB (voltage setting step S2). Thereafter, the lithium-ion secondary battery 10 is connected to the test power supply 20 to build the circuit 30 (circuit building step S3). In the state just after the circuit is built, the output voltage VS is equal to the battery voltage VB. Thus, no potential difference is made, and the leakage current IB flowing through the circuit 30 is zero. The battery voltage VB of the lithium-ion secondary battery 10 having been left to stand for a certain period of time in this state has dropped due to its self-discharge. This makes a potential difference between battery voltage VB and the output voltage VS, and thus, the leakage current IB flows through the circuit 30. When the self-discharge of the battery is saturated, the drop of the battery voltage VB converges, and the increase of the leakage current IB also converges (leakage current measuring step S4).

The convergence of the increase of the leakage current IB will be described further. First, the drop of the battery voltage VB is, as described above, because of the self-discharge of the lithium-ion secondary battery 10. This self-discharge causes a self-discharge current ID to flow through the electric generating element E of the lithium-ion secondary battery 10. The larger the amount of the self-discharge of the lithium-ion secondary battery 10 is, the larger the self-discharge current ID is; and the smaller the amount thereof is, the smaller the self-discharge current ID is. In contrast, the leakage current IB flowing due to the drop of the battery voltage VB flows in the direction of charging the lithium-ion secondary battery 10. That is, the leakage current IB acts to suppress the self-discharge of the lithium-ion secondary battery 10, and in the lithium-ion secondary battery 10, flows in the opposite direction of the self-discharge current ID. When the leakage current IB increases so that the intensity thereof becomes the same as the self-discharge current ID, the self-discharge substantially stops. This is the reason why the increase of the leakage current IB converges.

Here, the shunt resistance Rp varies according to the minute metallic foreign materials contaminated in the battery.

When the lithium-ion secondary battery 10 has the shunt resistance Rp of a small value, the amount of the voltage drop tends to be large, and the self-discharge current ID also tends to be large. Therefore, the leakage current IB of such a lithium-ion secondary battery 10 after having converged tends to be large.

Lastly, whether the lithium-ion secondary battery 10 is good or bad is determined based on the leakage current IB after having converged (determination step S5). Whether the leakage current IB converges or not may be determined by a known technique.

For example, one may sample the values of the leakage current IB at a proper frequency, and determine the convergence when the change of any value becomes smaller than a predetermined standard. Whether the battery is good or bad can be determined by determining whether or not the leakage current IB after having converged exceeds the standard value.

[Second Embodiment]

The feature of the second embodiment is to raise the voltage of the test power supply over time in the leakage current measuring step S4 of the first embodiment. According to this, the time until the increase of the leakage current converges can be shortened. That is, the time for the leakage current measuring step can be shortened. Hereinafter, the second embodiment will be described in detail.

The leakage current IB in the model circuit shown in Fig. 2 can be expressed by the following equation (1) using the output voltage VS, the battery voltage VB, and the parasitic resistance Rx:

$$(1): IB = (VS-VB)/Rx$$

When the output voltage VS is set to be constant as in the first embodiment, the drop of the battery voltage VB, which accompanies the self-discharge of the lithium-ion secondary battery 10, causes the leakage current IB to increase. When the leakage current IB increases to be equal to the self-discharge current ID, the lithium-ion secondary battery 10 substantially stops discharging. Thereby, after this, the battery voltage VB and the leakage current IB are each constant. That is, the leakage current IB after having converged indicates the self-discharge current ID of the electric generating element E of the lithium-ion secondary battery 10.

In the second embodiment, the output voltage VS is raised after the measurement starts. The equation (1) holds even in this case. In this case, the output voltage VS rises so that the leakage current IB increases faster than in the case where the output voltage VS is constant. Therefore, the time required for the leakage current IB to be equal to the self-discharge current ID shortens. This is the reason why the leakage current IB converges in an early stage. It is noted that raising the output voltage VS too much does not lead to proper convergence of the leakage current IB, and makes the determination whether the battery is good or bad difficult. Thus, it is necessary to limit the degree of the rise of the output voltage VS. Specifically, since the smaller the parasitic resistance Rx is, the larger the leakage current IB is, the output voltage VS is raised within such a range that the parasitic resistance Rx in the equation (1) seems to be smaller.

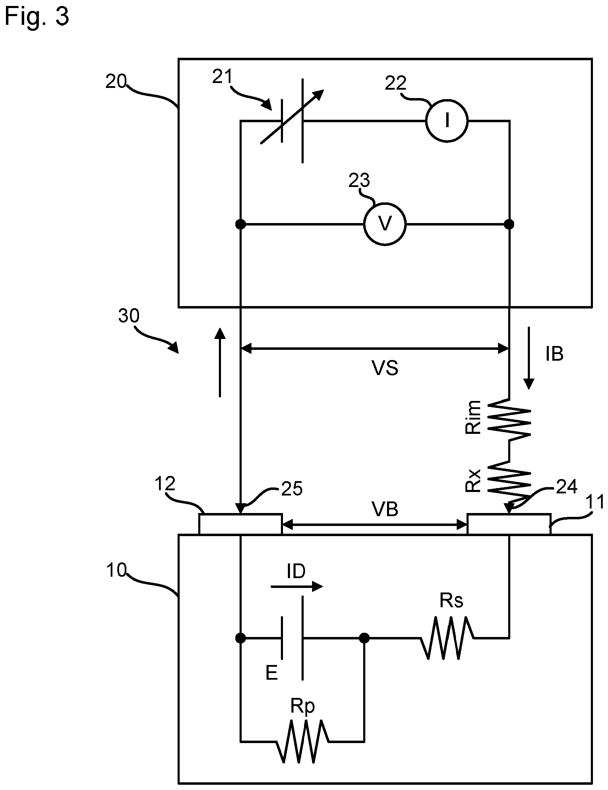

Then, in the second embodiment, the concept of virtual resistance Rim is introduced. Fig. 3 shows a model circuit in which the virtual resistance Rim is introduced. The virtual resistance Rim is a virtual resistance having a negative or zero resistance value. In the model circuit of Fig. 3, the virtual resistance Rim is inserted, so that the virtual resistance Rim and the parasitic resistance Rx are in series. However, as described above, in fact, such resistance is not present. Here, the situation where the output voltage VS rises is considered by replacing the circuit with the model in which the output voltage VS is constant and the absolute value of the resistance value of the virtual resistance Rim rises instead. Here, it is necessary that the sum of the parasitic resistance Rx and the virtual resistance Rim is positive (Rx + Rim > 0). The leakage current IB in the model circuit to which the virtual resistance Rim is introduced is expressed as the following equation (2).

Hereinafter the sum of the parasitic resistance Rx and the virtual resistance Rim may be referred to as pseudo-parasitic resistance Ry:

$$(2): IB = (VS\text{-}VB)/(Rx+Rim)$$

The equation (2) will be further described. For example, when the parasitic resistance Rx is 5 $\Omega$, the leakage current IB largely varies between the case where the virtual resistance Rim is 0 Q and the case where the virtual resistance Rim is -4 Q. That is, from the equation (2), the leakage current IB in the case where the virtual resistance Rim is -4 $\Omega$ (corresponding to the situation after the measurement starts) is five times as much as the leakage current IB in the case where the virtual resistance Rim is 0 $\Omega$ (corresponding to the situation at the time point when the measurement starts) because the pseudo-parasitic resistance Ry (= Rx + Rim) is one-fifth in the former case.

Here, the equation (2) is rearranged into the following equation (3).

$$(3): VS = VB + (Rx+Rim)*IB$$

The equation (3) shows that the sum of the battery voltage VB and the product of the pseudo-parasitic resistance Ry (= Rx + Rim) and the leakage current IB is equal to the output voltage VS. Since the virtual resistance Rim in the pseudo-parasitic resistance Ry is actually not present as described above, the equation (3) can hold when the output voltage VS is raised to the voltage that is the sum of the battery voltage VB and the product of the parasitic resistance Rx and the leakage current IB. That is, the value obtained by dividing, by the leakage current IB, the raised voltage in the output voltage VS corresponds to the absolute value of the virtual resistance Rim.

In the second embodiment, as described above, the measurement starts after the output voltage VS is matched to the battery voltage VB. Then, the output voltage VS is raised at a predetermined frequency according to the leakage current IB at this time, and according to the equation (3). Further, the leakage current IB increases as the output voltage VS rises (see the equation (1)). As described, in the second embodiment, the increase of the leakage current IB can be promoted, which can shorten the time until the increase of the leakage current IB converges. Here, the frequency at which the output voltage VS is raised is not particularly limited. For example, the frequency may be approximately once per second. The frequency is not necessary to be regular.

From the above, the rise of the output voltage VS for the increase of the leakage current IB is the product of the parasitic resistance Rx and the leakage current IB. In other words, the rise $\Delta$VS is given by the following equation (4) where $\Delta$VS is the rise of the output voltage VS:

$$(4): \Delta VS = Rx*IB$$

The rise $\Delta$VS is not limited to this, and may be the value obtained by multiplying the product in the formula (4) by a positive coefficient K that is less than 1. The coefficient K is any specific value as long as being within the above range, and may be fixed in advance.

In other words, the rise $\Delta$VS may be calculated by the following equation (5):

$$(5): \Delta VS = K*Rx*IB$$

One may obtain the product of this coefficient K and the parasitic resistance Rx in advance as a constant M, and calculate the rise $\Delta$VS of the output voltage VS by multiplying the leakage current IB by this constant M. When to do so, the output voltage VS during the test is calculated by the following equation (6):

$$(6): VS = VB + M*IB$$

It is most effective to use the product in the equation (4) as it is as the rise of the output voltage VS in view of converging the increase of the leakage current IB in an early stage. In this case, however, the accuracy of the value of the parasitic resistance Rx, and any other reasons may cause the pseudo-parasitic resistance Ry to be negative. In this case, the variations in the leakage current IB diverge so that it is probable that the leakage current cannot be measured properly. Then, the multiplication by the coefficient as described above allows the risk of the divergence to be avoided.

Here, it is necessary to know the value of the parasitic resistance Rx for actually performing the measurement by this method. The contact resistance between the probe 24 and the terminal 11, and between the probe 25 and the terminal 12 in the parasitic resistance Rx are each different between each circuit 30. However, for example, the parasitic resistance Rx including the contact resistance can be measured as follows. In the model circuit of Fig. 2, the output voltage VS of the test power supply 20 is turned off, and the reading of the voltmeter 23 is measured in the following two states: the state where both the terminals of the test power supply 20 are connected via known resistance; and the state where this connection is broken. Then, the parasitic resistance Rx can be calculated based on the resistance value of the known resistance, and the two readings of the voltmeter 23.

As described above, in the second embodiment, to raise the output voltage VS as feeding back the value of the leakage current IB to the output voltage VS allows the increase of the leakage current IB to converge in an early stage.

[Third Embodiment]

In the first and second embodiments, the voltage of the test power supply is set to be equal to that of the lithium-ion secondary battery in the voltage setting step S2. In contrast, the feature of the third embodiment is that the voltage of the test power supply is set higher than that of the lithium-ion secondary battery. According to this, the time for the leakage current measuring step S4 can be shortened. Hereinafter, the third embodiment will be described in detail. When the first to third embodiments are combined, the voltage of the test power supply may be set to be equal to or higher than that of the lithium-ion secondary battery in the voltage setting step S2.

First, the shunt resistance Rp of the model circuit of Fig. 2 is considered. As described above, the shunt resistance Rp is the model of minute metallic foreign materials contaminated in the battery. However, even a good battery which includes no minute metallic foreign materials at all slightly performs self-discharging. Therefore, the self-discharge produced by the lithium-ion secondary battery 10 is the sum of the self-discharge present even if the battery is good, and the self-discharge due to minute metallic foreign materials. In other words, the shunt resistance Rp is the parallel resistance of natural shunt resistance Rp0 and foreign material shunt resistance Rp1 where the natural shunt resistance Rp0 is the resistance in the self-discharge path which is present even when the battery is good, and the foreign material shunt resistance Rp1 is the resistance in the lead paths by the minute metallic foreign materials. Therefore, the self-discharge current which is fixed by the battery voltage VB and the natural shunt resistance Rp0 is produced in the lithium-ion secondary battery 10 even when the battery is good. When the lithium-ion secondary battery 10 is bad, the self-discharge current is produced more based on the foreign material shunt resistance Rp1.

Therefore, in the model circuit of Fig. 2, fixing the output voltage VS so that the output voltage VS can cancel out the self-discharge current based on the natural shunt resistance Rp0 causes the self-discharge current not to flow and the battery voltage VB to be kept constant if the battery is good. In this case, the leakage current IB does not change but is constant. That is, the leakage current IB does not increase but converges. On the contrary, even when the output voltage VS is fixed as described, the self-discharge current based on the foreign matter shunt resistance Rp1 also flows when the lithium-ion secondary battery 10 is bad, and thus, the battery voltage VB is dropping. In this case, the self-discharge current is increasing. Using such a principle allows the convergence of the leakage current to be determined in a shorter time than in the case where the output voltage VS is matched to the battery voltage VB.

The method of fixing the output voltage VS based on the above principle will be described. First, a self-discharge current ID0 when the battery is good is given by the following equation (7):

$$(7):\ \mathrm{ID0 = VB/Rp0}$$

This is cancelled out if the leakage current IB given by the equation (1) matches the self-discharge current ID0 in the equation (7). Therefore, the equation (8) holds.

$$(8):\ \mathrm{(VS-VB)/Rx = VB/Rp0}$$

When the equation (8) is rearranged to be solved for the output voltage VS, the equation (9) is obtained:

$$(9):\ \mathrm{VS = VB*\{1+(Rx/Rp0)\}}$$

Here, the natural shunt resistance Rp0 is almost fixed by the design of the lithium-ion secondary battery 10. Therefore, the natural shunt resistance Rp0 can be treated as a known value according to the specifications of the lithium-ion secondary battery 10. As described above, the parasitic resistance Rx is also a known value. Thus, the right side of the equation (9) is formed of known values only. Therefore, the output voltage VS at the time point when the measurement starts can be easily fixed. According to the equation (9), the output voltage VS fixed in this way is higher than the battery voltage VB by "VB*(Rx/Rp0)".

Here, according to the equation (7), the self-discharge current ID0 is the initial self-discharge current of the lithium-ion secondary battery 10 when the battery is good. When this is defined as a standard self-discharge current IDI, the equation (8) can be expressed as the following equation (10) with IDI. The output voltage VS at the time point when the measurement starts can be calculated by the equation (9) since the standard self-discharge current IDI is fixed by the natural shunt resistance Rp0, which is the design value, the battery voltage VB at the time point when the measurement starts, and the parasitic resistance Rx.

$$(10): VS = VB + (IDI*Rx)$$

If the leakage current IB does not increase but converges as it is even after the measurement starts when the output voltage VS higher than the battery voltage VB is used, the lithium-ion secondary battery 10 can be determined to be good ("initial current value = current converging value", which can be also expressed as "initial current value ≈ current converging value" because, actually, the current converging value does not always match the initial current value).

On the contrary, if the leakage current IB increases after the measurement starts, the lithium-ion secondary battery 10 can be determined to be bad (initial current value < current converging value).

Since the measured current values are very small, the influence of temperature, measurement errors, etc. may lead to "initial current value > current converging value", which is an exceptional case. Even in this case, the current converges later on. However, when the initial current value is too large, for example, when the initial current value is more than twice the current converging value, the convergence is delayed, or no convergence may be brought.

Here, when the leakage current IB increases after the measurement starts, the output voltage VS may be raised over time as in the second embodiment. According to this, the leakage current IB is allowed to converge in an early stage.

In order to easily determine whether the battery is a good or bad, a determination value of approximately 3 to 5 $\mu$A may be set for the increase of the leakage current IB. Then, whether the battery is a good or bad can be determined by determining whether or not the increase of the leakage current IB after the measurement starts is no less than the determination value. For example, approximately 20 to 30 minutes after the measurement starts may be set for the time point when the determination is performed.

Hereinbefore the method of testing the lithium-ion secondary battery of the present disclosure has been described with the first to third embodiments. The method of testing the lithium-ion secondary battery of the present disclosure enables whether the battery is good or bad to be determined with high accuracy in a short time even when lithium iron phosphate is used as a cathode active material.

(B) Method of Producing Lithium-Ion Secondary Battery

A method of producing a lithium-ion secondary battery according to the present disclosure is as follows. That is, the method of producing a lithium-ion secondary battery comprises: the making step of making the lithium-ion secondary battery comprising a cathode containing lithium iron phosphate as a cathode active material, an anode containing a carbon material as an anode active material, and an electrolyte layer arranged between the cathode and the anode; and the testing step of performing the above-described testing method. The making step and the testing step have been described above, and thus, the descriptions thereof will be omitted here.

The method of producing the lithium-ion secondary battery of the present disclosure enables whether the battery is good or bad to be determined with high accuracy in a short time, and thus, can suppress shipment of bad batteries, and shorten the production period.

Examples

Hereinafter, the present disclosure will be further described with the examples.

<Obtaining SOC-OCV Curve>

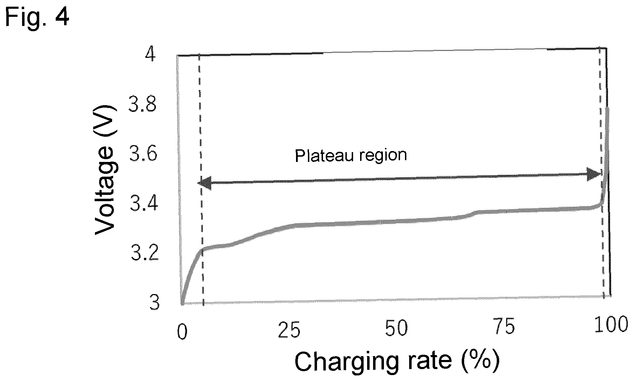

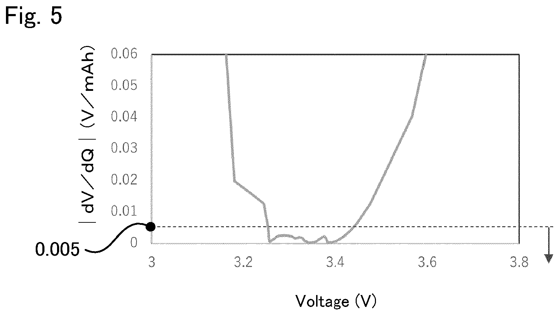

A charging rate-voltage curve was obtained using a lithium-ion secondary battery having the following structure. The charging conditions were as follows: the voltage ranged from 3 to 3.75 V; and the current was at 0.05 C/s. The result is shown in Fig. 4. Fig. 5 shows the correlation between the voltage and |dV/dQ| (where V is the voltage, and Q is the capacity).

(Structure of Lithium-Ion Secondary Battery)

    Cathode current collector: aluminum
    cathode active material: lithium iron phosphate

separator: polyethylene
anode active material: graphite
anode current collector: copper
nonaqueous electrolyte: a mixed solution of EC and EMC as a nonaqueous solvent. LiPF$_6$ was also used as a
supporting salt
capacity: 225 mAh

As shown in Fig 4, the plateau region of the lithium-ion secondary battery using lithium iron phosphate as a cathode active material was large. In Fig. 4, the region of the curve where the charging rate ranges from 7 to 99% corresponds to the plateau region. In Fig. 5, the region of the curve where |dV/dQ| is no more than 0.005 V/mAh corresponds to the plateau region.

<Measuring Leakage Current>

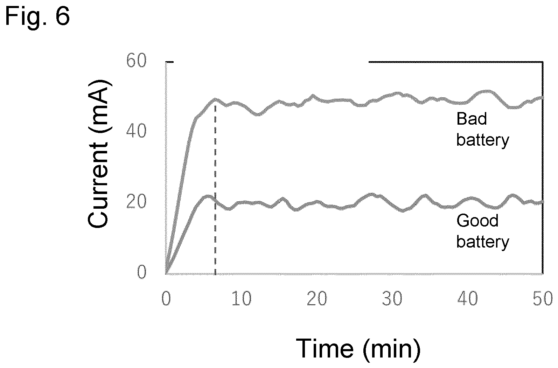

A leakage current was measured using a lithium-ion secondary battery having the following structure. As a testing device, a self-discharge measuring device (BT2152B) manufactured by Keysight Technologies was used. The battery to be used for the test had been determined to be good, and was adjusted to be at a charging rate of 88%. This battery was connected to the testing device, and then, the leakage current was measured: the voltage of the testing device was equal to that of the battery. Here, as a comparative example, a battery to which external resistance was connected was used to imitate a bad battery. In the measurement, the battery temperature (environment temperature) was set at 25°C. The results are shown in Fig. 6.

(Structure of Lithium-Ion Secondary Battery)

cathode current collector: aluminum
cathode active material : lithium iron phosphate
separator: polyethylene
anode active material: graphite
anode current collector: copper
nonaqueous electrolyte: a mixed solution of EC and EMC as a nonaqueous solvent. LiPF$_6$ was also used as a
supporting salt
capacity: 7 Ah

As shown in Fig. 6, the increase of the leakage current had converged in a few minutes in both the example (good battery) and the comparative example (bad battery). The value of the leakage current of the comparative example after having converged was apparently larger than that of the example. From the results, it was confirmed that whether each battery was good or bad was able to be determined with high accuracy in a short time by measuring the leakage current.

<Measuring Temperature Sensitivity>

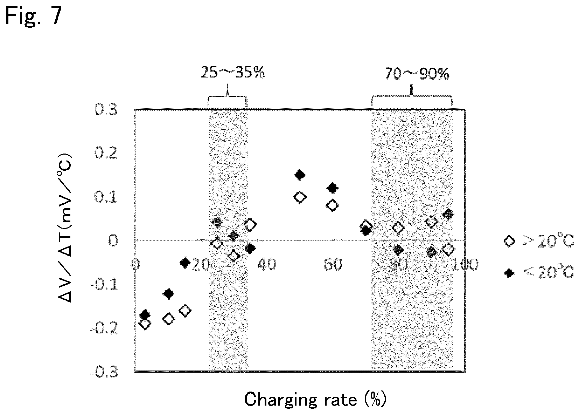

Temperature sensitivity was measured using a lithium-ion secondary battery having the following structure. Specifically, the voltage of the battery was measured as the charging rate thereof was adjusted to those shown in table 1. In that time, the environmental temperature was changed to 20°C (6 h), 21°C (6 h), 20°C (6 h), 19°C (6 h), and 20°C (6 h) in this order. The temperature sensitivity ΔV/ΔT (mV/°C) was calculated from each obtained voltage value V. The results are shown in table 1 and Fig. 7. The correlation between the charging rate and the temperature sensitivity was in accordance with Nernst equation.

(Structure of Lithium-Ion Secondary Battery)

cathode current collector: aluminum
cathode active material : lithium iron phosphate
separator: polyethylene
anode current collector: copper
nonaqueous electrolyte: a mixed solution of EC and EMC as a nonaqueous solvent. LiPF$_6$ was also used as a supporting salt
Anode active material: graphite
capacity: 7 Ah

[Table 1]

| (Table 1) | | | |
|---|---|---|---|
| > 20°C | | < 20°C | |
| Charging rate (%) | $\Delta mV/\Delta T$ (mV/°C ) | Charging rate (%) | $\Delta mV/\Delta T$ (mV/°C ) |
| 3 | -0.19 | 3 | -0.17 |
| 10 | -0.18 | 10 | -0.12 |
| 15 | -0.16 | 15 | -0.05 |
| 25 | -0.01 | 25 | 0.04 |
| 30 | -0.03 | 30 | 0.01 |
| 35 | 0.04 | 35 | -0.02 |
| 50 | 0.10 | 50 | 0.15 |
| 60 | 0.08 | 60 | 0.12 |
| 70 | 0.03 | 70 | 0.02 |
| 80 | 0.03 | 80 | -0.02 |
| 90 | 0.04 | 90 | -0.03 |
| 95 | -0.02 | 95 | 0.06 |

As shown in table 1 and Fig. 7, the results of extremely low temperature sensitivity were obtained when the charging rate of the battery was in the range of 25 to 35% or 70 to 90%. Specifically, when the charging rate was in this range, the temperature sensitivity $\Delta V/\Delta T$ was within $\pm 0.05$ mV/°C. From this, it was found out that when the charging rate of the battery was in the range of 25 to 35% or 70 to 90%, the temperature sensitivity was low, and thus, the voltage change based on the temperature sensitivity was stable. Therefore, it was considered that whether the battery was good or bad can be determined with higher accuracy by adjusting the charging rate within the above range.

Reference Signs List

10 lithium-ion secondary battery
11 cathode terminal
12 anode terminal
20 test power supply
21 DC power supply
22 ammeter
23 voltmeter
24, 25 probe
30 circuit

Claims

1. A method of testing a lithium-ion secondary battery, the battery comprising a cathode containing lithium iron phosphate as a cathode active material, an anode containing a carbon material as an anode active material, and an electrolyte layer arranged between the cathode and the anode, **characterised in that** the method comprises:

adjusting a charging rate of the lithium-ion secondary battery to be in a plateau region and to be in the range from 25 to 35% or 70 to 90%;

setting voltage of a test power supply to a voltage equal to or higher than voltage of the lithium-ion secondary battery;

building a circuit by connecting the lithium-ion secondary battery and the test power supply;

measuring a leakage current that flows through the circuit until the leakage current converges; and

determining whether the lithium-ion secondary battery is good or bad based on the leakage current after the leakage current has converged.

2. The method according to claim 1, wherein in said measuring a leakage current, the voltage of the test power supply is raised over time.

3. The method according to claim 1 or 2, wherein

in said adjusting a charging rate, the charging rate of the lithium-ion secondary battery is adjusted, so that dV/dT is -0.05 mV/°C to 0.05 mV/°C where V is the voltage of the lithium-ion secondary battery, and T is temperature of the lithium-ion secondary battery.

4. A method of producing a lithium-ion secondary battery, the method comprising:

making the lithium-ion secondary battery comprising a cathode containing lithium iron phosphate as a cathode active material, an anode containing a carbon material as an anode active material, and an electrolyte layer arranged between the cathode and the anode; and

performing the testing method according to claim 1 or 2.

**Patentansprüche**

1. Verfahren zum Testen einer Lithium-Ionen-Sekundärbatterie, die Batterie umfassend eine Kathode, die Lithiumeisenphosphat als aktives Kathodenmaterial enthält, eine Anode, die ein Kohlenstoff-Material als aktives Anodenmaterial enthält, und eine Elektrolytschicht, die zwischen der Kathode und der Anode angeordnet ist, **dadurch gekennzeichnet, dass** das Verfahren Folgendes umfasst:

Anpassen einer Laderate der Lithium-Ionen-Sekundärbatterie, so dass sie in einem Plateaubereich ist und in dem Bereich von 25 bis 35 % oder 70 bis 90 % ist;

Einstellen der Spannung einer Teststromversorgung auf eine Spannung, die größer oder gleich der Spannung der Lithium-Ionen-Sekundärbatterie ist;

Aufbauen eines Stromkreises durch Verbinden der Lithium-Ionen-Sekundärbatterie und der Teststromversorgung;

Messen eines Leckstroms, der durch den Stromkreis fließt, bis der Leckstrom konvergiert; und

Bestimmen, ob die Lithium-Ionen-Sekundärbatterie gut oder schlecht ist, auf der Grundlage des Leckstroms, nachdem der Leckstrom konvergiert ist.

2. Verfahren nach Anspruch 1, wobei bei dem Messen eines Leckstroms die Spannung der Teststromversorgung mit der Zeit erhöht wird.

3. Verfahren nach Anspruch 1 oder 2, wobei bei dem Anpassen einer Laderate die Laderate der Lithium-Ionen-Sekundärbatterie so angepasst wird, dass dV/dT - 0,05 mV/°C bis 0,05 mV/°C ist, wobei V die Spannung der Lithium-Ionen-Sekundärbatterie ist und T eine Temperatur der Lithium-Ionen-Sekundärbatterie ist.

4. Verfahren zum Herstellen einer Lithium-Ionen-Sekundärbatterie, das Verfahren Folgendes umfassend:

Anfertigen der Lithium-Ionen-Sekundärbatterie, die eine Kathode, die Lithiumeisenphosphat als aktives Kathodenmaterial enthält, eine Anode, die ein Kohlenstoff-Material als aktives Anodenmaterial enthält, und eine Elektrolytschicht umfasst, die zwischen der Kathode und der Anode angeordnet ist; und

Durchführen des Testverfahrens nach Anspruch 1 oder 2.

**EP 4 390 415 B1**

**Revendications**

1. Procédé de test d'une batterie secondaire au lithium-ion, la batterie comprenant une cathode contenant du phosphate de fer lithié comme matériau actif de cathode, une anode contenant un matériau de carbone comme matériau actif d'anode, et une couche d'électrolyte agencée entre la cathode et l'anode, **caractérisé en ce que** le procédé comprend :

   l'ajustement du taux de charge de la batterie secondaire au lithium-ion pour qu'il se situe dans une zone de plateau et qu'il soit dans la plage de 25 à 35 % ou de 70 à 90 % ;
   le réglage de la tension d'une alimentation de test à une tension égale ou supérieure à la tension de la batterie secondaire au lithium-ion ;
   la construction d'un circuit en connectant la batterie secondaire au lithium-ion et l'alimentation de test ;
   la mesure d'un courant de fuite qui circule dans le circuit jusqu'à ce que le courant de fuite converge ; et
   la détermination si la batterie secondaire au lithium-ion est bonne ou mauvaise sur la base du courant de fuite après la convergence du courant de fuite.

2. Procédé selon la revendication 1, lors de ladite mesure d'un courant de fuite, la tension de l'alimentation de test étant augmentée au fil du temps.

3. Procédé selon la revendication 1 ou 2,
   au cours dudit ajustement d'un taux de charge, le taux de charge de la batterie secondaire au lithium-ion étant ajusté, de sorte que dV/dT est de -0,05 mV/ °C à 0,05 mV/ °C, V étant la tension de la batterie secondaire au lithium-ion, et T étant la température de la batterie secondaire au lithium-ion.

4. Procédé de production d'une batterie secondaire au lithium-ion, le procédé comprenant :

   la fabrication de la batterie secondaire au lithium-ion comprenant une cathode contenant du phosphate de fer lithié comme matériau actif de cathode, une anode contenant un matériau carbone comme matériau actif d'anode, et une couche d'électrolyte agencée entre la cathode et l'anode ; et
   la réalisation du procédé de test selon la revendication 1 ou 2.

# Fig. 1

| | |
|---|---|
| | Start |
| S1 | Charging rate adjusting step |
| S2 | Voltage setting step |
| S3 | Circuit building step |
| S4 | Leakage current measuring step |
| S5 | Determination step |
| | End |

Fig. 2

Fig. 3

Fig. 4

Fig. 5

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019113450 A